Europäisches Patentamt

**European Patent Office**

**Office européen des brevets**

(11) Publication number: **0 155 726**
**A1**

(12) # EUROPEAN PATENT APPLICATION

(21) Application number: **85200275.7**

(51) Int. Cl.⁴: **G 01 N 27/30**

(22) Date of filing: **27.02.85**

(30) Priority: **28.02.84 NL 8400612**

(43) Date of publication of application:
**25.09.85 Bulletin 85/39**

(84) Designated Contracting States:
**DE FR GB IT NL**

(71) Applicant: **CORDIS EUROPA N.V.**
**Oosteinde 8**
**NL-9301 LJ Roden(NL)**

(72) Inventor: **Ligtenberg, Hendrikus Cornelis Geert**
**Johannes Vermeerstraat 15**
**NL-9312 PZ Nietap(NL)**

(74) Representative: **Urbanus, Henricus Marìa, Ir. et al,**
**c/o Vereenigde Octrooibureaux Nieuwe Parklaan 107**
**NL-2587 BP 's-Gravenhage(NL)**

(54) Chemically sensitive field-effect transistor component.

(57) A chemically sensitive field-effect transistor (ISFET) component has enhanced insulation properties. The source and drain regions are provided in an island provided on a substrate, wherein the island is doped with a type of impurity opposite to that with which the substrate is doped. This defines a PN insulation junction between the island and the substrate.

EP 0 155 726 A1

FIG.1

# CHEMICALLY SENSITIVE FET COMPONENT

## Background of the Invention

The invention relates to a chemically sensitive FET component and, more particularly, to an improved component for reducing adverse affects of leakage current.

A field-effect transistor (FET) sensitive to ions or molecular substances is a device finding rapidly increasing employment in measuring systems for, for example, determining the concentration of a particular type of ion in a liquid and monitoring changes in the concentration of this type of ion.

A chemically sensitive field-effect transistor (FET) component is based on a MOSFET, sometimes known as an IGFET, having an insulated gate. The metal gate of the MOSFET is replaced by an electrically insulating layer, such as silicon dioxide. A prior art example is set forth in the U.S. Patent to C. Johnson et al., 4,020,830.

0155726

Such an ion-selective field-effect transistor (ISFET) can be used, for example, for in vivo measurement of the pH of blood when mounted in a catheter adapted for insertion into the human bloodstream and connected as a sensor in an appropriate electrical measuring circuit, additionally including a reference electrode. Such use of the ISFET implies that the elements of the ISFET chip playing an active part in the measurement are to be exposed to the electrolyte. The remainder of the chip, however, should be hermetically sealed against electrical contact with the electrolyte and should accordingly be provided with an enclosure. The manufacture of a hundred percent electrically insulating enclosure presents a technical problem, especially when mass fabricating sensors which, in a miniature housing, are to remain for a long period of time in the liquid to be measured and which should satisfy high demands as to accuracy. One of the reasons for this is that the ISFET sensor itself has very small dimensions of about 1 x 2 mm, while the gate region within which the chemically selective coating is located is of even smaller dimensions, i.e., about 20 x 400 um. Practice has shown that the liquid to be measured will eventually penetrate to the ISFET sensor chip, resulting in a leakage current flowing via the reference electrode to the bulk, source or drain of the ISFET chip. In general, the intensity of this leakage current will increase with time. Due to the relatively high impedance of most reference electrodes (10 to 20 kOhm), the leakage current contributes to the electrochemical potential difference between the reference electrode and the chemically selective surface coating of the ISFET. As the measuring system is unable to distinguish such a contribution from a measuring signal caused by a change in the chemical composition of the liquid to be measured, the leakage current has a detrimental effect on the accuracy of the ISFET measuring system. Consequently, the problem of the occurrence of measuring errors caused by an ineffective enclosure is really an insulation problem.

The prior art relating to ISFET components includes the British Application to K. Shimada et al., GB 2 010 011 A, published on June 20, 1979 which provides a double layer structure including a silicon dioxide layer covering the whole chip except for the side where the bonding pads are situated as, for example, is shown in Fig. 5J and Fig. 5K. This layer is overlaid with a second electrical insulating layer of silicon nitride. This represents an improvement in insulating properties over the ISFET disclosed in the Johnson patent, supra. However, such a double insulation layer is believed complicated to manufacture.

## Summary of the Invention

Accordingly, it is an object of the invention to provide a chemically sensitive FET component having enhanced electrical insulation achieved in a manner suitable for inclusion in the manufacturing procedure of FET components and of chemically sensitive sensors and measuring systems employing such FET components.

To achieve this object, in accordance with the invention a chemically sensitive FET component of the type described above is characterized in that the source and the drain are located in an island provided on and/or in the substrate, which island is of the semiconductor material but doped with a type of impurity opposite to that with which the substrate is doped to thereby define a PN insulation junction therebetween.

### Brief Description of the Drawings

The invention will now be described in greater detail with reference to the accompanying drawings, in which:

Figures 1a and 1b schematically show a cross-sectional view of an ISFET component on the basis of a p type impurity doped silicon substrate and a diagram of the circuit arrangement to be realized in practice on the basis of such an ISFET component, respectively;

Figures 2a and 2b schematically show a cross-sectional view of an ISFET component on the basis of an n type impurity doped silicon substrate and a diagram of the circuit arrangement to be realized on the basis of such an ISFET component, respectively;

Figure 3 is a top view of the component in Figure 1a;

Fig. 4 is a sectional view taken generally along line 4-4 in Figure 3 looking in the direction of the arrows; and,

Fig. 5 is a sectional view taken generally along line 5-5 in Figure 3 looking in the direction of the arrows.

## Description of Preferred Embodiment

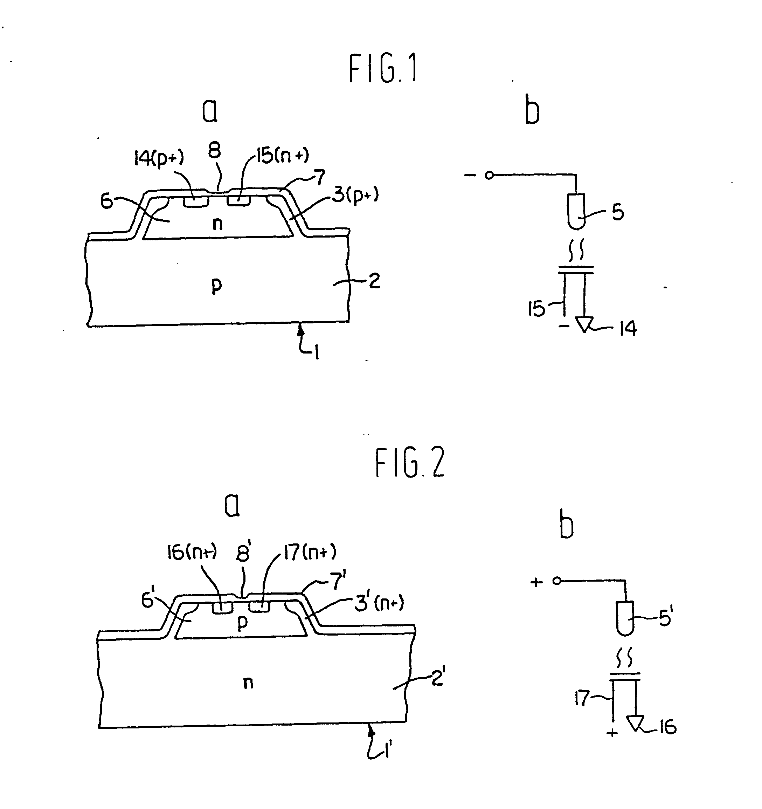

For convenience, the invention will be described with reference to Figures 1 and 3-5. A similar description applies to Figure 2 except for the fact that in this Figure 2 the polarities of the silicon semiconductor material are opposite to those according to Figure 1.

In Figure 1a the ISFET component 1 comprises the substrate 2 of p silicon including an island 6 of n silicon having its side walls 3 coated with p+ silicon. Regions 14 and 15 in island 6 are the p+ source and the p+ drain, respectively, formed by diffusion. The ISFET component has its, in the drawing, upper side provided with an electrically insulating layer 7 of silicon dioxide. A chemically selective coating, for example, a pH-sensitive membrane, is provided in the gate region 8 in a manner not shown in the drawings. Furthermore, the ISFET 1 is provided in the usual manner with an enclosure, not shown, of electrically insulating material exposing only the gate region for allowing the chemically selective membrane to contact the liquid, such as blood, to be examined.

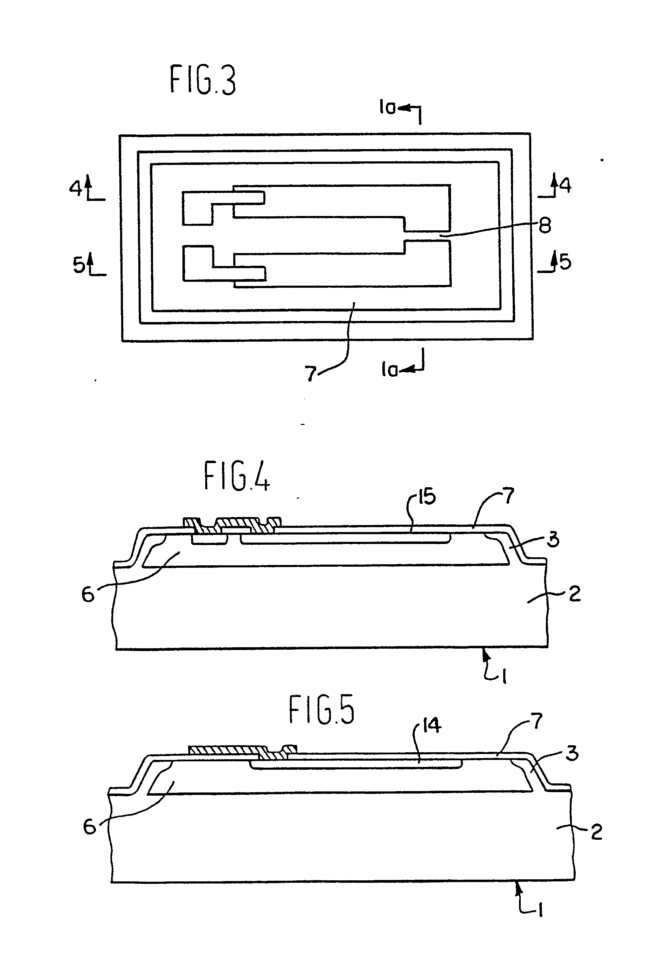

As seen in Figures 3-5, the component 1 is an elongated rectangular shaped structure. As seen in Figure 3, the source and drain regions are elongated L-shaped regions having their short legs facing each other and spaced apart to define the gate region 8 therebetween. The other ends of the regions 14 and 15 are each electrically connected with a metal bonding pad for wire connections externally of the component.

As shown in Figure 1b, the measuring circuit comprises a reference electrode 5 expediently being an Ag/AgCl electrode, which reference electrode is placed in the liquid under examination together with the ISFET. When using the ISFET component shown in Figure 1a, the voltage of reference electrode 5 should be negative with respect to that of source 14 as shown in the diagram of Figure 1b. In the case of the ISFET component shown in Figure 2, in which the polarities of the silicon used in substrate 2', island 6', source 16 and drain 17 are opposite to those of the ISFET component shown in Figure 1, the voltage of reference electrode 5' should accordingly be positive with repect to that of source 16.

The operating point of the reference electrode is so chosen within the measuring system that electrical current occurring thereat has to pass a reverse biased p-n junction.

In general, the leakage currents which may occur will have very low intensity on the order of nA and such leakage currents are now limited by the blocked p-n junction. This blocking is achieved by the PN insulation junction between the island 6 and the substrate 2. Additional blocking is achieved by the PN insulation junction between the island and the impurity doped side walls 3. Consequently, the maximum leakage current traversing the measuring system is no longer determined by the quality of the insulation of the enclosure. Leakage currents through the insulation are now of consideration only when such currents can flow to the lead wires on the chip owing to the presence of liquid on the insulation. As this leakage path will, in general, be far longer than the original path to the bulk of the chip, use of the same encapsulation results in a far longer service life of the sensor.

The islands 6, 6' of silicon doped with a type of impurity opposite to that with which the silicon substrate is doped can be obtained in various manners. One possible method is to provide the island by diffusion or by implantation, after which the source and drain regions are provided in the island by diffusion.

In accordance with another possible method, one can start from n-on-p or p-on-n epitaxial wafers and realize the insulation according to the invention by separation diffusions resulting in the formation of separated regions in which the ISFET component can be placed. Furthermore, it is also possible, again starting from the n-on-p or p-on-n epitaxial wafers, to provide slots therein which intersect the epitaxial layer and to subsequently insulate the side walls of the thus mechanically separated islands by coating these walls with an electricaly insulating material and/or by diffusing into these walls a dopant of opposite impurity type.

The on-chip insulation renders the method of enclosing the extremely small ISFET component less critical. The provision of the insulation itself can conveniently be realized in charge-wise manner through on-wafer technology, the junction insulation resulting, moreover, in a longer service life and improved stability of the reference electrode.

Self-evidently, changes may be made in the chemically sensitive FET component described above and shown in the drawings without departing from the scope of the invention.

## C L A I M S

1. A chemically sensitive field effect transistor, comprising:

a substrate of a first conductivity type impurity doped semiconductor material;

laterally spaced apart source and drain regions of said first conductivity type impurity doped semiconductor material located at the upper surface of said substrate and separated from the bulk thereof;

a layer of electrically insulating material covering the upper surface of the substrate including at least a portion of the source and drain regions and the area therebetween and which is adapted for receiving a chemically selected coating thereon;

an island in said substrate of a second conductivity type impurity doped semiconductor material and forming a PN insulation junction therewith, said source and drain regions being located in the upper surface of said island whereby they are separated from the bulk of said substrate by said island.

2. A chemically sensitive field effect transistor as set forth in claim 1 wherein said semiconductor material is silicon.

3. A chemically sensitive field effect transistor as set forth in claim 1 wherein said island is a raised island extending above the bulk of said substrate and said insulation junction.

4. A chemically sensitive field effect transistor as set forth in claim 3 wherein said island has upstanding side walls extending from said substrate to the upper surface of said island, said side walls being coated with a layer of said first conductivity type impurity doped semiconductor material so as to form a PN insulation junction therewith.

5. A chemically sensitive field effect transistor as set forth in claim 4 wherein said layer on said side walls is more heavily doped with said first type impurity doped semiconductor material than that of said substrate.

6. A method of manufacturing a chemically sensitive field effect transistor which comprises the steps of:

providing a substrate of a first type conductivity impurity doped semiconductor material;

providing an island on the upper surface of said substrate with said island being of the second conductivity type impurity doped semiconductor material to define a PN insulation junction therebetween and having an upper surface separated from the bulk of said substrate;

diffusing source and drain regions into the upper surface of said island so as to be spaced apart from each other;

covering the upper surface of said island with a layer of electrically insulating material so as to cover at least portions of the source and drain regions and the surface area of said island between said source and drain regions.

7.    A method as set forth in claim 6 wherein said island is formed in the upper surface of said substrate by diffusion.

8.    A method as set forth in claim 6 wherein said island is formed in the upper surface of said substrate by implantation.

9.    A method of manufacturing a chemically sensitive field effect transistor comprising the steps of:

providing an epitaxially formed wafer having a first layer and a second layer with said first layer being of a first conductivity type impurity doped semiconductor material and said second layer being of an opposite second conductivity type impurity doped semiconductor material so as to define a PN insulation junction therebetween,

forming a pair of spaced apart slots in the second layer so as to intersect with said first layer defining an island having side walls defined by said slots;

coating the side walls with an insulating layer of a first conductivity type impurity doped semiconductor material thereby defining a PN insulation junction between the side walls of said island and said insulating layer thereon;

diffusing spaced apart source and drain regions into the upper surface of said island with said source and drain regions being of said first conductivity type impurity doped semiconductor material,

applying a layer of electrically insulating material over the upper surface of said island so as to cover at least a portion of the source and drain regions and the area between said regions.

FIG.1

a

14(p+) 8 15(n+)
6 7
3(p+)
n
p
2
1

b

−
5
15
14
−

FIG.2

a

16(n+) 8' 17(n+)
6' 7'
p
3'(n+)
n
2'
1'

b

+
5'
17
16
+

FIG.3

FIG.4

FIG.5

## EUROPEAN SEARCH REPORT

Application number

EP 85 20 0275

### DOCUMENTS CONSIDERED TO BE RELEVANT

| Category | Citation of document with indication. where appropriate, of relevant passages | Relevant to claim | CLASSIFICATION OF THE APPLICATION (Int Cl 4) |
|---|---|---|---|
| A | US-A-4 322 680 (J.JANATA)<br>* Column 4, line 30 - column 6, line 43; figures 2-4 * | 1 | G 01 N 27/30 |
| D,A | GB-A-2 010 011 (K.SHIMADA)<br>* First page * | 1 | |
| A | EP-A-0 083 815 (B.SINGER)<br>* First page * | 1 | |
| A | US-A-4 055 884 (C.G.JAMBOTKAR)<br>* First page * | 1 | |

TECHNICAL FIELDS
SEARCHED (Int. Cl.4)

G 01 N

The present search report has been drawn up for all claims

| Place of search | Date of completion of the search | Examiner |
|---|---|---|
| THE HAGUE | 30-05-1985 | DUCHATELLIER M.A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document. but published on, or after the filing date
D : document cited in the application
L : document cited for other reasons

& : member of the same patent family, corresponding document

EPO Form 1503. 03 82